# EUROPEAN PATENT SPECIFICATION

(11) **EP 0 645 054 B1**
(45) Date of publication and mention of the grant of the patent: **13.11.1996**
(21) Application number: 92914216.4
(22) Date of filing: 11.06.1992
(51) Int. Cl.: H01L 31/08, G01J 5/20

(54) **TWO-LEVEL MICROBRIDGE BOLOMETER IMAGING ARRAY AND METHOD OF MAKING SAME**
ABBILDENDE BOLOMETER MATRIX AUF ZWEI NIVEAUS AUS MIKROBRÜCKEN UND VERFAHREN ZU DESSEN HERSTELLUNG.
GROUPEMENT DE PHOTODETECTEURS DE BOLOMETRE A MICROPONT A DEUX NIVEAUX ET PROCEDE DE FABRICATION

(43) Date of publication of application: 29.03.1995
(73) Proprietor: HONEYWELL INC., Minneapolis Minnesota 55408 (US)
(72) Inventor: HIGASHI, Robert, E., Shorewood, MN 55331 (US); JOHNSON, Robert, G., Minnetonka, MN 55343 (US); HOLMEN, James, O., Minnetonka, MN 55343 (US)
(74) Representative: Fox-Male, Nicholas Vincent Humbert
(86) International application number: US9204895
(87) International publication number: WO9326050

(56) References cited:
- WO-A-90/16082
- US-A- 5 008 541

## Description

### FIELD OF THE INVENTION

The field of the invention is in a two-level infrared bolometer array based on a pitless microbridge detector structure with integrated circuitry on a silicon substrate beneath.

### BACKGROUND AND SUMMARY OF THE INVENTION

This invention is directed to a pixel size sensor of an array of sensors for an infrared pitless microbridge construction of high fill factor. In this invention the large fill factor (>75%) is made possible by placing the detector microbridge on a second plane above the silicon surface carrying the integrated diode and bus lines.

Prior art microbridge thermal detector arrays in a silicon substrate have been fabricated and one such example is shown in the US patent 3,801,949. In this prior art reference, the small pixels have a low fill factor because the detector, the bus lines and the diode are all in the same plane, each using a substantial share of the available pixel area.

### BRIEF DESCRIPTION OF THE DRAWING

Figure 1 is a cross-sectional view of the two-level detector.

Figure 2 is an elevation view of the two-level detector.

Figure 3 is a plan view of the top plane of the detector.

Figure 3a shows adjoining detectors.

Figure 4 is a schematic representation of a pixel circuit and connections.

Figure 5 and 6 show perspective and top views of an array of the two-level detectors.

### DESCRIPTION

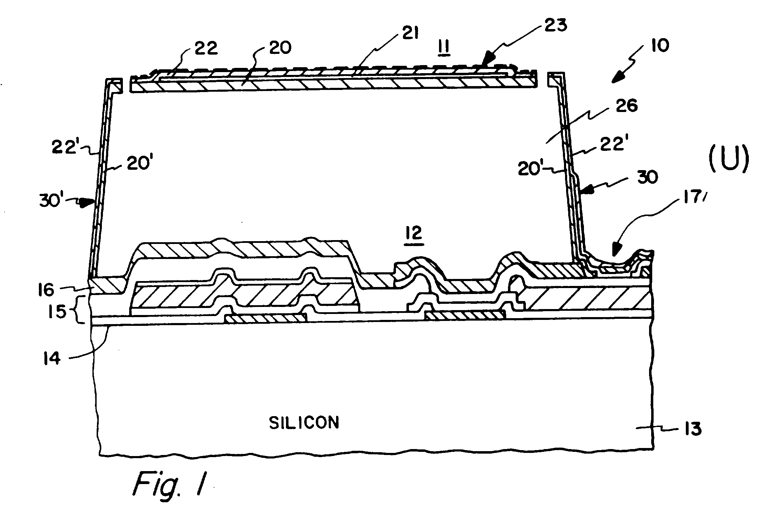

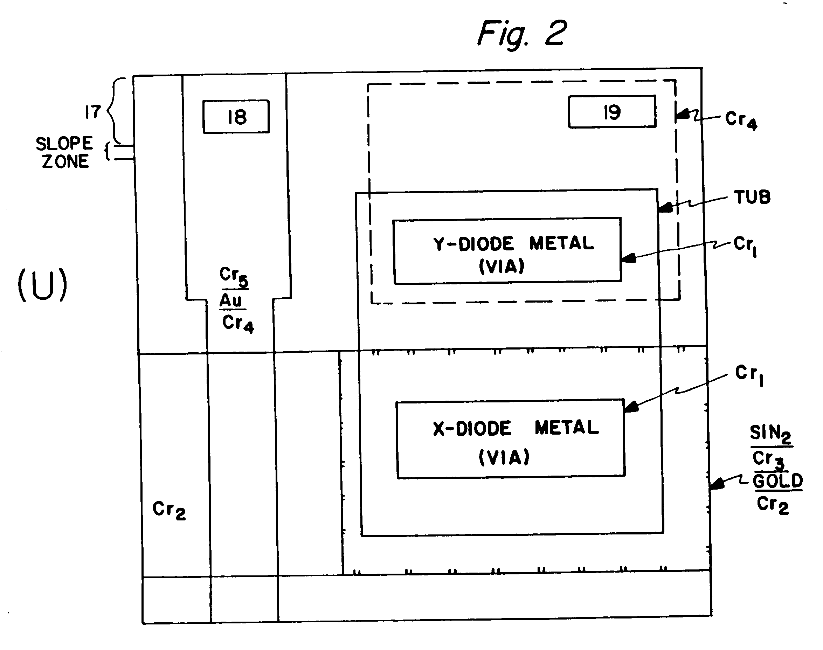

The elevation and/or cross section view of the two-level pitless microbridge bolometer pixel 10 is shown in Figure 1. The device 10 has two levels, an elevated microbridge detector 11 and lower level 12. The lower level has a flat surfaced semiconductor substrate 13, such as single crystal silicon substrate. The surface 14 of the silicon substrate 13 has fabricated thereon several components of an integrated circuit 15 including diodes, x and y bus lines, connections, and contact pads at the ends of the x and y bus lines, the fabrication following conventional silicon IC technology. The integrated circuit 15 is coated with a protective layer of silicon nitride 16. A top plan view of the lower level is shown in Figure 2 and comprises a y-diode metal (via) and an x-diode metal (via), chrome-gold-chrome x and y bus lines, a y-side bus conductor contact 18, an x-side contact 19, and the silicon nitride protective layer. The valley strip 17 is the area not covered by the elevated detector.

Referring again to Figure 1, the elevated detector level 11 includes a silicon nitride layer 20, a serpentine metallic resistive layer 21, such as of nickel-iron, often called permalloy, a silicon nitride layer 22 over the layers 20 and 21, and an IR absorber coating 23 over the silicon nitride layer 22. The absorber coating may also be of a nickel-iron alloy. Downwardly extending silicon nitride layers 20' and 22' deposited at the same time during the fabrication make up the four sloping support legs for the elevated detector level. The number of support legs may be greater or less than four. The cavity 26 (approximately 3 micrometers high) between the two levels is ambient atmosphere. During the fabrication process, however, the cavity 26 was originally filled with a previously deposited layer of easily dissolvable glass or other dissolvable material until the layers 20, 20' and 22, 22' were deposited. Subsequently in the process the glass was dissolved out to leave the cavity. In Figure 1 the horizontal dimension, as shown, is greatly foreshortened for descriptive purposes. That is, the height of Figure 1 is greatly exaggerated in the drawing compared to the length in order to show the details of the invention.

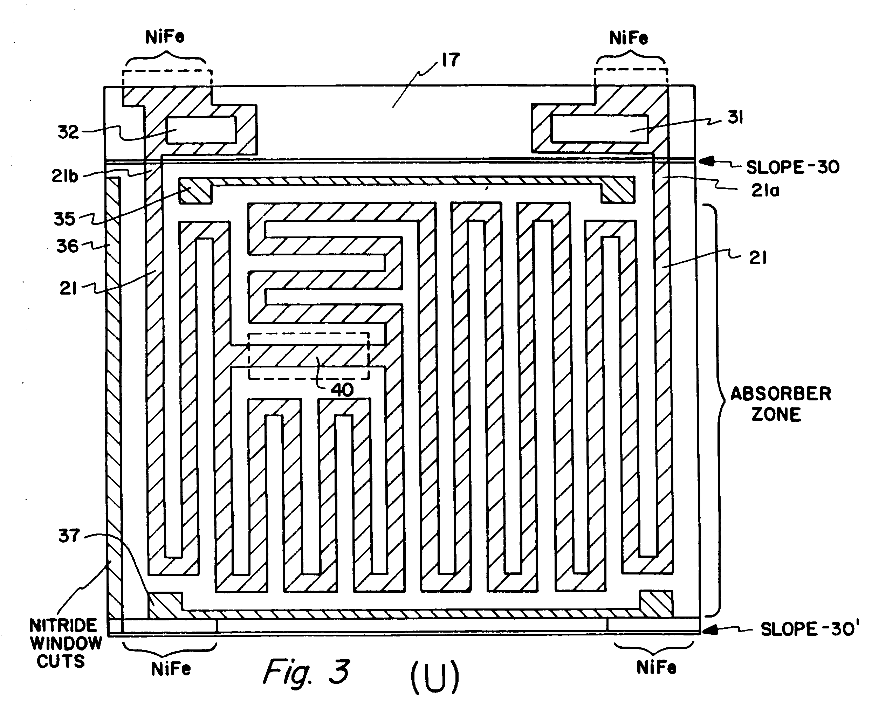

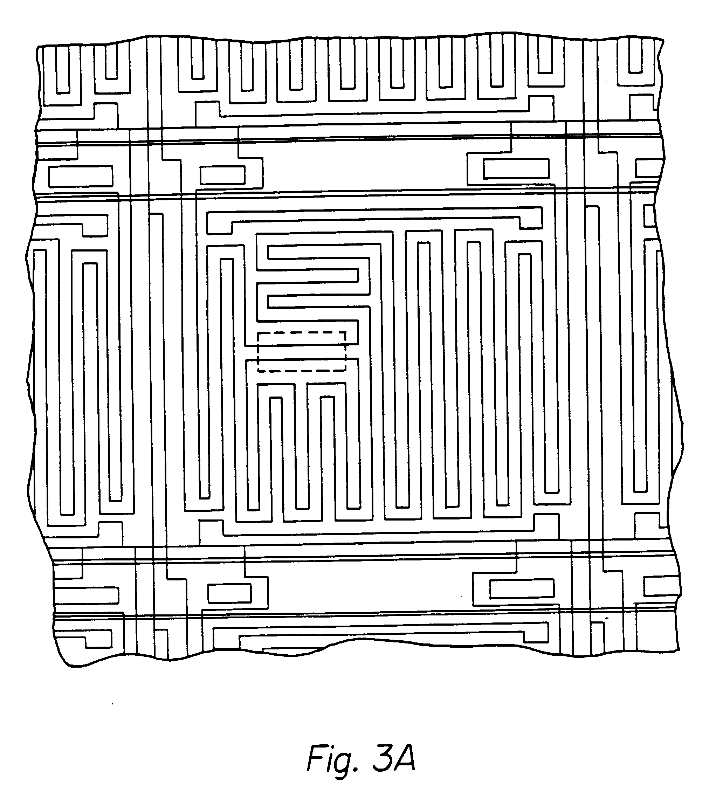

Figure 3 is a top plan view of the elevated detector level 11. This drawing is made as though the overlying absorber coating 23 and upper silicon nitride layer 22 are transparent so the serpentine resistive layer path 21 can be shown. The exact layout of the serpentine pattern 21 is not significant to the invention. The resistive lines and spaces may be about 1.5 micrometer. Permalloy was selected as the material for the resistive path 21 in one embodiment because of its relatively high resistivity together with a good temperature coefficient of resistance. In one embodiment the resistivity was on the order of 2500 ohms, with a fill factor of about 75 %. The ends of the resistive paths 21a and 21b are continued down the slope area 30 to make electrical contact with pads 31 and 32 on the lower level.

Figure 3 also shows nitride window cuts 35, 36 and 37 which are opened through the silicon nitride layers 20 and 22 to provide access to the phos-glass beneath for dissolving it from beneath the detector plane. These nitride cuts may be made by ion milling or other suitable process. It may be noted that the ion milled cuts 35, 36 and 37 to provide this access are very narrow (< 2 micrometers) and are shared with adjacent pixels on the sides, (see Figure 3a), thus maximizing the area available to the detector and thus maximizing the resulting fill-factor. The four supporting legs may be as short or as long as necessary to provide adequate support and thermal isolation. With the detector thickness of 300 nm or less, the thermal impedance is high over the entire detector film. Consequently, short legs should not contribute excessively to the conductance. Figure 3a shows that the adjacent identical pixels are in close proximity.

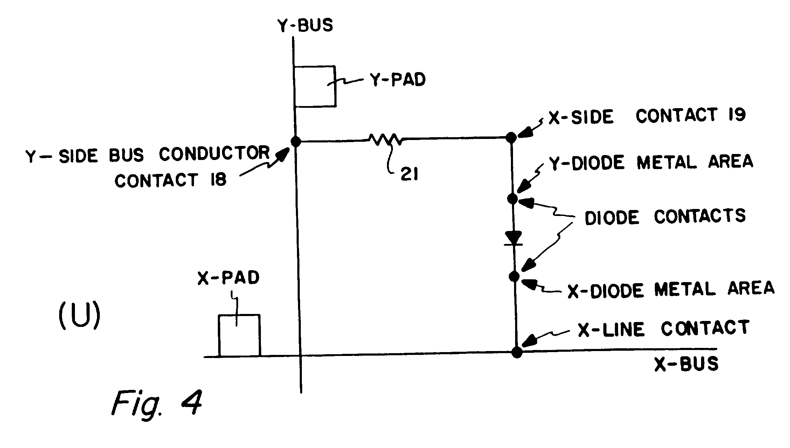

Figure 4 is a schematic representation of a pixel circuit shown in the other figures comprising the sensing element 21 and the connections to it which are clearly labeled on the drawing.

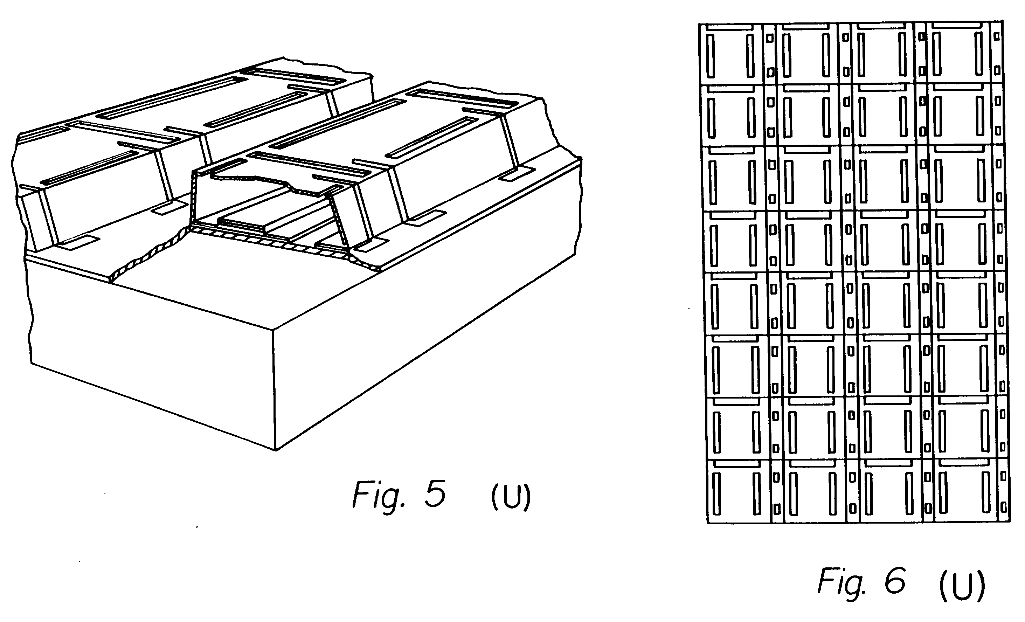

Although the description has been basically in terms of individual detector pixels, the invention is directed to an x,y array assembly of adjoining pixels forming an imaging or mosaic detector array. Each pixel assembly may cover an area about 50 micrometers on a side, for example. Figures 5 and 6, as well as Figure 3a show a section of the array. Figure 5 shows in perspective the sensing ridges of abutting sensors in a column. This figure is partially cut away to show the lower level and the cavity as well. The ridges may be about 40 micrometers wide, so that the elevated detector pixels 11 are on the order of 50x40 micrometers.

Figure 6 is a top view block diagram of Figure 5. In the operation of an array of this general type, a suitable IR lens system is usually used to focus a scene onto the array of pixels. A chopper may be used if desired to interrupt the incoming IR energy in synchronism with the related utilizing video electronics. The focused scene heats each pixel according to the energy of the received scene at each pixel position and changes the resistance of the resistive layer 21 according to the pixel temperature.

Further described below is a sequence of fabrication steps for the upper level. Following the deposition of the silicon nitride layer 16 in fabricating the lower level 12 and the cuts of the x-side contact area 19, the y-side busconductor contact area 18, the cuts of the x-pads and y-pads, the lower level of electronic components and conductors is complete. The construction of the upper level 11 is then ready to commence. A layer of phos-glass or other easily soluble material approximately 3 micrometers thick is deposited and delineated along x-direction strips and the strip slopes 30 and 30' are thoroughly rounded to eliminate slope coverage problems. In the delineation the glass is cut to less than one micrometer on the strip 17. The remaining glass is cut to open the strip, and the external glass areas including the x-pad and the y-pad. The upper plane silicon nitride base layer 20 is then deposited, the nickel-iron resistance layer 21 is deposited, delineated, and connected to the lower plan contacts 18 and 19, and covered with silicon nitride passivation layer 22. The trim site 40 (Figure 3) is cut, x-pads and y-pads are opened, the absorber coating 23 is deposited and delineated, and finally the side slots 35, 36 and 37 are ion milled allowing the phos-glass to be dissolved from beneath the detector plane.

## Claims

1. A two-level microbridge bolometer imaging array comprising:
an array of bolometer pixels on a semi-conductor substrate (13), each one of said pixels (10) having a lower section (12) on the surface (14) of the substrate (13) and a microbridge upper detector plane (11) spaced from and immediately above the lower section;
said lower section (12) including a semiconductor diode, x and y bus lines and x and y pads,
said microbridge upper detector plane (11) comprising a bridging dielectric layer (20, 22) having embedded throughout a temperature responsive resistive element (21) having first and second terminals (21a, 21b), said microbridge upper detector plane (11) being supported above the lower section (12) by dielectric leg portions (20', 22') which are downward extending continuation of the bridging dielectric layer (20, 22);
said first and second terminals (21a, 21b) being continued down said leg portions to said diode and one of said bus lines.

2. The imaging array according to claim 1 wherein said dielectric layer (20, 22) is of silicon nitride.

3. The imaging array according to claim 2 wherein said silicon nitride layer comprises a first layer (20) beneath said temperature responsive resistive element and a second layer (22) over said first layer and said element (21).

4. The imaging array according to claim 1 wherein said temperature responsive resistive element (21) is of a nickel-iron alloy.

5. The imaging array according to claim 1 wherein the microbridge upper detector plane (11) is raised about 3 micrometers above the lower section (12).

6. A method of fabricating a two-level microbridge bolometer imaging array comprising the steps of:
forming on a silicon substrate (13) a lower level (12) of diodes and other components, column and row bus connectors, and x and y contact pads covered by a first dielectric;
opening contact areas through the first dielectric to one of said bus conductors and to one of said diodes contact areas in each pixel (10) of the array, and to said x and y contact pads at the ends of the bus lines;
coating said first dielectric with a layer of glass;
cutting narrow valleys through the glass along the array column conductors and removing the glass from outside the area of the array, and sloping the edges of the remaining glass ridges to accept further coating;
coating the glass ridges and edges with a first thin film layer (20) of silicon nitride;
opening contact areas through the first layer of silicon nitride to one of said bus conductors, and one of said diodes in each pixel of the array, and to the x and y pads;
patterning on the first layer of silicon nitride on each pixel and between the bus line contact area and the diode contact area on each pixel, a separation path (21) of resistive metal which has a substantial temperature coefficient of resistance;
adding a second layer (22) of silicon nitride over the first and over the resistive metal path (21) to passify it, said silicon nitride layers forming an elevated plane;
cutting a narrow slit through the silicon nitride to the glass between adjoining pixels, and cutting additional narrow slits in each pixel area to provide further access to the glass, and cutting the nitride from the x and y pad areas; and
dissolving the glass beneath the silicon nitride layers to leave a cavity between the lower level and the elevated plane.

7. The method according to claim 6 wherein said first dielectric is of silicon nitride.

8. The method according to claim 6 wherein the resistive metal is an allow of nickel-iron.

9. The method according to claim 6 wherein the layer thickness of the glass is about three micrometers.

10. The method according to claim 6 wherein the cavity is about three micrometers high.

## Patentansprüche

1. Mikrobrücken-Bolometer-Abbildungsmatrix auf zwei Niveaus, aufweisend: eine Matrix von Bolometer-Pixeln auf einem Halbleitersubstrat (13), wobei jedes der Pixel (10) einen unteren Abschnitt (12) auf der Oberfläche (14) des Substrates (13) und eine obere Mikrobrücken-Detektorebene (11) im Abstand und unmittelbar oberhalb des unteren Abschnittes aufweist;
wobei der untere Abschnitt (12) eine Halbleiterdiode, x- und y-Busleitungen und x- und y-Kissen umfaßt,
wobei die obere Mikrobrücken-Detektorebene (11) eine überbrückende dielektrische Schicht (20, 22) aufweist, die in ihr eingebettet ein temperaturempfindliches Widerstandselement (21) mit ersten und zweiten Anschlüssen (21a, 21b) besitzt, und
die obere Mikrobrücken-Detektorebene (11) über dem unteren Abschnitt (12) durch dielektrische Beinteile (20', 22') abgestützt ist, die sich nach unten in Fortsetzung der überbrückenden dielektrischen Schicht (20, 22) erstrecken;
wobei die ersten und zweiten Anschlüsse (21a, 21b) sich von den Beinteilen nach unten zu der Diode und einer der Busleitungen fortsetzen.

2. Abbildungsmatrix nach Anspruch 1, wobei die dielektrische Schicht (20, 22) aus Siliziumnitrid besteht.

3. Abbildungsmatrix nach Anspruch 2, wobei die Siliziumnitridschicht eine erste Schicht (20) unterhalb des temperaturempfindlichen Widerstandselementes und eine zweite Schicht (22) über der ersten Schicht und dem Element (21) umfaßt.

4. Abbildungsmatrix nach Anspruch 1, wobei das temperaturempfindliche Widerstandselement (21) aus einer Nickel-Eisen-Legierung besteht.

5. Abbildungsmatrix nach Anspruch 1, wobei die obere Mikrobrücken-Detektorebene (11) sich ungefähr 3 Mikrometer über den unteren Abschnitt (12) erhebt.

6. Verfahren zur Herstellung einer Mikrobrücken-Bolometer-Abbildungsmatrix auf zwei Niveaus, umfassend die Schritte:
Bildung auf einem Siliziumsubstrat (13) von einer unteren Ebene (12) von Dioden, von Spalten- und Zeilen-Busleitungen, und x- und y-Kontaktkissen, die durch ein erstes Dielektrikum abgedeckt sind;
Öffnung von Kontaktbereichen durch das erste Dielektrikum zu einer der Busleitungen und zur einem der Dioden-Kontaktbereiche in jedem Pixel (10) der Matrix und zu den x- und y-Kontaktkissen an den Enden der Busleitungen;
Beschichtung des ersten Dielektrikums mit einer Glasschicht;
Schneiden von schmalen Kehlen durch das Glas entlang der Matrix-Spaltenleitungen und Entfernung des Glases von außerhalb des Matrixbereiches und Neigung der Kanten der verbleibenden Glaserhebungen, um eine weitere Beschichtung aufzunehmen;
Beschichtung der Glaserhebungen und der Kanten mit einer ersten Dünnfilmschicht (20) aus Siliziumnitrid;
Öffnung von Kontaktbereichen durch die erste Schicht aus Siliziumnitrid zu einer der Busleitungen und einer der Dioden in jedem Pixel der Matrix und zu den x- und y-Kissen;
Musterung einers Trennpfades (21) aus Widerstandsmetall, das einen wesentlichen Widerstands-Temperaturkoeffizienten besitzt, auf der ersten Schicht von Siliziumnitrid auf jedem Pixel und zwischen dem Busleitungs-Kontaktbereich und dem Dioden-Kontaktbereich auf jedem Pixel;
Hinzufügung einer zweiten Schicht (22) aus Siliziumnitrid über der ersten Schicht und über dem Widerstands-Metallpfad (21), um sie zu passivieren, wobei die Siliziumnitridschichten eine angehobene Ebene bilden;
Schneiden eines schmalen Schlitzes durch das Siliziumnitrid zu dem Glas zwischen angrenzenden Pixeln und Schneiden von zusätzlichen schmalen Schlitzen in jeden Pixelbereich, um einen weiteren Zugriffzu dem Glas vorzugeben, und Abtrennung des Nitrides von den x- und y-Kissenbereichen; und
Auflösung des Glases unterhalb der Siliziumnitridschichten, um eine Ausnehmung zwischen dem unteren Niveau und der angehobenen Ebene zu belassen.

7. Verfahren nach Anspruch 6, wobei das erste Dielektrikum aus Siliziumnitrid besteht.

8. Verfahren nach Anspruch 6, wobei das Widerstandsmetall aus einer Legierung von Nickel-Eisen besteht.

9. Verfahren nach Anspruch 6, wobei die Schichtdicke des Glases ungefähr 3 Mikrometer beträgt.

10. Verfahren nach Anspruch 6, wobei die Ausnehmung eine Höhe von ungefähr 3 Mikrometer aufweist.

## Revendications

1. Matrice d'imagerie de bolomètre à micropont à deux niveaux comprenant:
une matrice de pixels de bolomètre sur un substrat semiconducteur (13), chacun desdits pixels (10) disposant d'une partie inférieure (12) sur la surface (14) du substrat (13) et d'un plan de détecteur supérieur à micropont (11) espacé par rapport à la partie inférieure et immédiatement au-dessus de celle-ci;
ladite partie inférieure (12) incluant une diode semi-conductrice, des lignes de bus x et y et des plots x et y,
ledit plan supérieur de détecteur à micropont (11) comprenant une couche diélectrique formant un pont (20, 22) disposant d'éléments résistants sensibles à la température (21) encastrés sur celle-ci, pourvus de première et seconde bornes (21a, 21b), ledit plan supérieur de détecteur à micropont (11) étant supporté au-dessus de la partie inférieure (12) par des parties pattes diélectriques (20', 22') qui s'étendent en continuation vers le bas de la couche diélectrique formant pont (20, 22);
lesdites première et seconde bornes (21a, 21b) se prolongeant en bas desdites parties pattes vers ladite diode et l'une desdites lignes de bus.

2. Matrice d'imagerie selon la revendication 1, dans laquelle ladite couche diélectrique (20, 22) est en nitrure de silicium.

3. Matrice d'imagerie selon la revendication 2, dans laquelle ladite couche de nitrure de silicium comprend une première couche (20) située au-dessous dudit élément résistant sensible à la température et une seconde couche (22) située au-dessus de ladite première couche et dudit élément (21).

4. Matrice d'imagerie selon la revendication 1, dans laquelle ledit élément résistant sensible à la température (21) est composé d'un alliage nickel-fer.

5. Matrice d'imagerie selon la revendication 1, dans laquelle le plan supérieur de détecteur à micropont (11) est surélevé de 3 microns environ au-dessus de la partie inférieure (12).

6. Procédé de fabrication d'une matrice d'imagerie de bolomètre à micropont à deux niveaux comprenant les étapes de:
formation sur un substrat en silicium (13) d'un niveau inférieur (12) de diodes et autres composants, connecteurs de bus de colonnes et rangées, et plots de contacts x et Y recouverts par un premier diélectrique;
ouverture de zones de contact à travers le premier diélectrique vers l'un desdits conducteurs de bus et vers l'une desdites zones de contact de diodes dans chaque pixel (10) de la matrice, et vers lesdits plots de contact x et Y aux extrémités des lignes de bus;
dépôt d'une couche de verre sur ledit premier diélectrique;
découpe de sillons étroits à travers le verre le long des conducteurs des colonnes de matrice et élimination du verre par l'extérieur de la zone de la matrice, et formation de plans inclinés sur les bords des arêtes en verre restantes afin de recevoir d'autres revêtements;
dépôt d'une première couche en film mince (20) de nitrure de silicium sur les arêtes et bords en verre;
ouverture des zones de contact à travers la première couche de nitrure de silicium vers l'un desdits conducteurs de bus, et l'une desdites diodes dans chaque pixel de la matrice, et vers les plots x et y;
dessin d'un circuit de séparation (21) en métal résistant qui présente un coefficient de résistance en fonction de la température important sur la première couche de nitrure de silicium de chaque pixel et entre la zone de contact de ligne de bus et la zone de contact de diode de chaque pixel ;
ajout d'une seconde couche (22) en nitrure de silicium sur la première couche et sur le circuit en métal résistant (21) afin de le passiver, lesdites couches de nitrure de silicium formant un plan supérieur;
découpe d'une fente étroite à travers le nitrure de silicium vers le verre entre les pixels adjacents, et découpe de fentes étroites supplémentaires dans chaque zone de pixel pour obtenir un autre accès vers le verre, et découpe du nitrure à partir des zones de plots x et y; et
dissolution du verre au-dessous des couches de nitrure de silicium afin de créer une cavité entre le niveau inférieur et le plan supérieur.

7. Procédé selon la revendication 6, dans lequel ledit premier diélectrique est du nitrure de silicium.

8. Procédé selon la revendication 6, dans lequel le métal résistant est un alliage nickel-fer.

9. Procédé selon la revendication 6, dans lequel l'épaisseur de la couche du verre est de trois microns environ.

10. Procédé selon la revendication 6, dans lequel la hauteur de la cavité est de trois microns environ.
